# EUROPÄISCHE PATENTANMELDUNG

(11) **EP 4 163 049 A1**
(43) Veröffentlichungstag der Anmeldung: **12.04.2023**
(21) Anmeldenummer: 21201813.9
(22) Anmeldetag: 11.10.2021
(51) Int. Cl.: B23K 31/02, B23K 35/24, B23K 101/36, H05K 3/34

(54) **VERFAHREN ZUM HERSTELLEN EINER LÖTVERBINDUNG SOWIE BAUGRUPPE MIT LÖTVERBINDUNG**

(71) Anmelder: Siemens Aktiengesellschaft, 80333 München (DE)
(72) Erfinder: Baar, Christian, 85757 Karlsfeld (DE); Schwarz, Markus, 80798 München (DE); Stegmeier, Stefan, 81825 München (DE)
(74) Vertreter: Siemens Patent Attorneys

(57) **Zusammenfassung**

Es wird ein Verfahren zum Herstellen einer Lötverbindung zwischen einem ersten Lötpartner (10) und einem zweiten Lötpartner (20) durch ein Lotmittel (100) angegeben,
wobei das Lotmittel ein metallisches Lotmaterial (110) und eine Vielzahl von magnetischen Nanopartikeln (120) umfasst, wobei das Verfahren zumindest die folgenden Schritte aufweist:
a) Erzeugung eines magnetischen Wechselfelds (200) mit wenigstens einer Magnetspule (210,220) und Einwirkung des magnetischen Wechselfeldes (200) auf das Lotmittel (100),
b) Erhitzung der magnetischen Nanopartikel (120) durch die Wechselwirkung mit dem magnetischen Wechselfeld (200),
c) Aufschmelzen des metallischen Lotmaterials (110) aufgrund von Wärmeübertragung (300) von den magnetischen Nanopartikeln (120) auf das metallische Lotmaterial (110) und Ausbildung der Lötverbindung zwischen dem ersten Lötpartner (10) und dem zweiten Lötpartner (20) durch das geschmolzene metallische Lotmaterial (110).

Weiterhin wird eine Baugruppe (1) mit einer entsprechenden Lötverbindung angegeben.

## Beschreibung

Die vorliegende Erfindung betrifft ein Verfahren zum Herstellen einer Lötverbindung zwischen einem ersten Lötpartner und einem zweiten Lötpartner durch ein Lotmittel, wobei das Lotmittel ein metallisches Lotmaterial umfasst, das während des Verfahrens aufgeschmolzen wird. Weiterhin betrifft die Erfindung eine Baugruppe mit einer derart hergestellten Lötverbindung.

Aus dem Stand der Technik sind verschiedene Lötverfahren bekannt, mit denen eine Lötverbindung zwischen mehreren Lötpartnern geschaffen werden kann. Das Verbindungsmaterial kann dabei beispielsweise ein festes Lotmittel wie z.B. ein Lotdraht oder ein Preform sein. Es kann aber auch eine Lotpaste zum Einsatz kommen, die beispielsweise über ein Druckverfahren auf einem zu bestückenden Schaltungsträger appliziert werden kann. Solche Lotpasten enthalten meist eine Vielzahl von metallischen Lotpartikeln und zusätzlich ein Flussmittel. Unabhängig von der jeweiligen Art des Lotmittels muss das darin enthaltene metallische Material aufgeschmolzen werden oder zumindest so stark erhitzt werden, dass eine Diffusion an den Grenzflächen möglich ist, um die gewünschte Lötverbindung zu erzeugen. Der hierzu benötigte Wärmeeintrag kann nach dem Stand der Technik beispielsweise über einen Lötkolben, die Flamme eines Lötbrenners, über Heißluft, heißen Dampf, Wärmestrahlung, einen Laser oder durch elektromagnetische Induktion mittels eines Induktors erfolgen.

Viele dieser Erwärmungsverfahren sind mit dem Nachteil verbunden, dass die Wärme nicht nur lokal an der Lötstelle, sondern in einem viel größeren Bereich in die Lötpartner eingetragen wird und somit die Gefahr einer thermischen Schädigung der Lötpartner besteht. Dies gilt vor allem für den Lötkolben, den Lötbrenner, die Heißluft, den heißen Dampf und die Wärmestrahlung. Mit einem Laser kann zwar unter Umständen eine lokal fokussierte Erwärmung erfolgen, allerdings sind oft nicht alle zu lötenden Bereiche (z.B. in einer elektrischen Baugruppe) für einen Laserstrahl offen zugänglich. Auch beim Induktionslöten besteht häufig die Gefahr der thermischen Schädigung anderer elektrisch leitfähiger Elemente in der Nähe der Lötstelle, in denen unerwünschte Wirbelströme induziert werden.

Ein weiterer Nachteil der genannten Erwärmungsverfahren besteht darin, dass es schwierig ist, die im Bereich der Lötstelle erreichte Temperatur genau zu messen und zu kontrollieren und somit einen übermäßig hohen Wärmeeintrag zu unterbinden, wenn die für die Erzeugung der Lötverbindung benötigte Temperatur erreicht ist. Daher wird meist deutlich mehr Wärme eingetragen als für den Lotprozess nötig wäre, was entsprechend zu einer noch stärkeren thermischen Belastung der Lötpartner bzw. weiterer benachbarter Bauteile führt.

Aufgabe der Erfindung ist es daher, ein alternatives Verfahren zur Herstellung einer Lötverbindung anzugeben, welches die genannten Nachteile überwindet. Insbesondere soll ein Lötverfahren zur Verfügung gestellt werden, welches einen räumlich eng begrenzten Wärmeeintrag im Bereich der Lötstelle ermöglicht und vorteilhaft auch eine besser kontrollierbare Begrenzung der erreichten Löttemperatur erlaubt. Eine weitere Aufgabe ist es, eine Baugruppe mit einer solchen Lötverbindung anzugeben.

Diese Aufgaben werden durch das in Anspruch 1 beschriebene Verfahren und die in Anspruch 13 beschriebene Baugruppe gelöst.

Das erfindungsgemäße Verfahren dient zur Herstellung einer Lötverbindung zwischen einem ersten Lötpartner und einem zweiten Lötpartner durch ein Lotmittel. Dieses Lotmittel umfasst ein metallisches Lotmaterial und eine Vielzahl von magnetischen Nanopartikeln. Das Verfahren umfasst die folgenden Verfahrensschritte:
a) Erzeugung eines magnetischen Wechselfelds mit wenigstens einer Magnetspule und Einwirkung des magnetischen Wechselfeldes auf das Lotmittel,
b) Erhitzung der magnetischen Nanopartikel durch die Wechselwirkung mit dem magnetischen Wechselfeld,
c) Aufschmelzen des metallischen Lotmaterials aufgrund von Wärmeübertragung von den magnetischen Nanopartikeln auf die Lotpartikel und Ausbildung der Lötverbindung zwischen dem ersten Lötpartner und dem zweiten Lötpartner durch das geschmolzene metallische Lotmaterial.

Dabei zeigt die genannte Reihenfolge der drei Verfahrensschritte a) bis c) in erster Linie eine Kausalität der einzelnen Effekte auf: Die Erzeugung des magnetischen Wechselfelds in Schritt a) bewirkt zunächst die Erhitzung der magnetischen Nanopartikel gemäß Schritt b), und diese Erhitzung der magnetischen Nanopartikel führt wiederum zum Aufschmelzen des Lotmaterials in Schritt c), da Wärme von den magnetischen Nanopartikel auf das Lotmaterial übertragen wird. Insgesamt laufen die Schritte a) und b) dabei typischerweise gleichzeitig ab, und Schritt c) verläuft auch entweder im Wesentlichen gleichzeitig oder zumindest zeitlich überlappend mit den Schritten a) und b).

Wesentlich für die vorliegende Erfindung ist also, dass das Lotmittel sowohl die beschriebenen magnetischen Nanopartikel als auch das metallische Lotmaterial enthält. Durch das Aufschmelzen des metallischen Lotmaterials wird die eigentliche Lötverbindung ausgebildet, ähnlich wie bei einer herkömmlichen Lotpaste. Die endgültige, mechanisch dauerhafte Lötverbindung wird dabei in dem Moment gebildet, in dem der Wärmeeintrag unterbunden bzw. begrenzt wird und das Lotmaterial wieder zu einem Festkörper erstarrt. Entsprechend wird die elektrische Leitfähigkeit der gebildeten Lötverbindung im Wesentlichen durch das erstarrte metallische Lotmaterial vermittelt.

Die zusätzlich vorliegenden magnetischen Nanopartikel dienen dazu, einen gezielten lokalen Wärmeeintrag in das Lotmittel zu ermöglichen. Diese Nanopartikel sind insbesondere ferromagnetisch oder ferrimagnetisch. Sie können also durch das in Schritt a) einwirkende magnetische Wechselfeld periodisch magnetisiert werden. Die Größenskala dieser Partikel soll im Nanometerbereich oder darunter liegen. Aufgrund dieser geringen Partikelgröße bleibt die durch das Magnetfeld bewirkte Magnetisierung nicht erhalten, sondern wird durch Brown-Relaxation und Neel-Relaxation auf einer sehr kurzen Zeitskala in thermische Energie umgewandelt. So kann über das in Schritt a) einwirkende magnetische Wechselfeld eine lokal begrenzte Erwärmung in der Zone bewirkt werden, in dem die magnetischen Nanopartikel vorliegen - mit anderen Worten lokal auf den Bereich des Lotmittels begrenzt. Ein wesentlicher Vorteil des erfindungsgemäßen Verfahrens liegt somit darin, dass die unerwünschte Erwärmung der zu verbindenden Lotpartner sowie anderer benachbarter Bauteile im Vergleich zu anderen Lötverfahren stark reduziert werden kann und trotzdem ein zuverlässiges Aufschmelzen der metallischen Lotkomponente innerhalb der Lötzone erreicht wird.

Innerhalb des Lotmittels kann das Lotmaterial insbesondere in Form von metallischen Lotpartikeln vorliegen. Dabei können die magnetischen Nanopartikel so mit den metallischen Lotpartikeln vermischt sein bzw. so nah zu diesen benachbart sein, dass insgesamt ein Wärmeübertrag von den zunächst erwärmten magnetischen Nanopartikeln auf die metallischen Lotpartikel möglich ist und die Lotpartikel daraufhin aufschmelzen können. Dies ist zum Beispiel bei einem Gemisch gegeben, bei denen beide Partikelsorten nebeneinander vorliegen, wobei insbesondere die typischerweise wesentlich kleineren magnetischen Nanopartikel im Wesentlichen gleichmäßig über die Lücken zwischen den größeren Lotpartikeln verteilt sind. Alternativ zu einem solchen Partikel-Gemisch ist es aber auch möglich, dass das Lotmittel eine Vielzahl von metallischen Lotpartikeln enthält, welche jeweils magnetische Nanopartikel als abgegrenzte Einschlüsse aus Fremd-Material umfassen. Bei einer weiteren Alternative können die magnetischen Nanopartikel auch in einen größer ausgedehnten Körper aus festem Lotmaterial eingebettet sein, beispielsweise über das Volumen eines sogenannten Preform-Körpers oder eines Lotdrahts verteilt sein.

Die erfindungsgemäße Baugruppe weist einen ersten Lötpartner und einen zweiten Lötpartner auf. Diese beiden Lötpartner sind durch eine Lötverbindung verbunden, welche eine metallische Lotkomponente und eine Vielzahl von darin eingebetteten magnetischen Nanopartikeln umfasst. Diese Lötverbindung ist insbesondere mit dem erfindungsgemäßen Verfahren hergestellt, was an dem Vorliegen der eingebetteten magnetischen Nanopartikel erkennbar ist. Im Unterschied zum metallischen Lotmaterial schmelzen die magnetischen Nanopartikel nicht beim Herstellen der Lötverbindung auf, sondern sind in dem erstarrten Lotmittel weiterhin als nanoskalige Einschlüsse erhalten. Die Vorteile der erfindungsgemäßen Baugruppe ergeben sich analog zu den oben beschriebenen Vorteilen des erfindungsgemäßen Verfahrens.

Vorteilhafte Ausgestaltungen und Weiterbildungen der Erfindung gehen aus den von den Ansprüchen 1 und 13 abhängigen Ansprüchen sowie der folgenden Beschreibung hervor. Dabei können die beschriebenen Ausgestaltungen des Verfahrens und der Baugruppe allgemein vorteilhaft miteinander kombiniert werden.

So können die magnetischen Nanopartikel gemäß einer allgemein vorteilhaften Ausführungsform superparamagnetisch sein. Mit anderen Worten umfassen die Nanopartikel ein ferromagnetisches oder ferrimagnetisches Material, und bei diesen Partikeln wird nach Abschalten eines zuvor einwirkenden äußeren Magnetfeldes auch unterhalb der Curie-Temperatur keine bleibende Magnetisierung aufrechterhalten. Dieser Effekt tritt aufgrund der geringen Partikelgröße auf, wobei die Partikelgröße, die hierfür unterschritten werden muss, auch abhängig vom jeweils vorliegenden Material ist. Allgemein vorteilhaft ist es jedoch in diesem Zusammenhang, wenn die magnetischen Nanopartikel einen Durchmesser von 100 nm oder weniger aufweisen. Bei nicht sphärischen Partikeln soll hier anstelle des Durchmessers die maximale äußere Abmessung herangezogen werden. Ein allgemein vorteilhafter Bereich für die typische Partikelgröße liegt beispielsweise zwischen 10 nm und 50 nm, besonders vorteilhaft zwischen 10 nm und 25 nm. Bei magnetischen Nanopartikeln der beschriebenen Größenskala kann Energie aus dem einwirkenden magnetischen Wechselfeld besonders effizient durch Brown- und Neel-Relaxation in eine Erwärmung der Nanopartikel umgesetzt werden.

Weiterhin ist es allgemein vorteilhaft, wenn die magnetischen Nanopartikel eine Curie-Temperatur aufweisen, welche in einem Bereich zwischen 100 °C und 1200 °C, besonders vorteilhaft zwischen 150 °C und 400 °C, liegt. Insbesondere sollen alle vorliegenden magnetischen Nanopartikel eine Curie-Temperatur im genannten Bereich aufweisen. Damit ist die Curie-Temperatur an den Temperaturbereich des verwendeten Lötprozesses angepasst. Insbesondere liegt die Curie-Temperatur der magnetischen Nanopartikel dabei oberhalb der Schmelztemperatur bzw. oberhalb des Schmelzbereichs des metallischen Lotmaterials. Auf diese Weise kann erreicht werden, dass die magnetischen Nanopartikel in dem einwirkenden magnetischen Wechselfeld auf eine ausreichend hohe Temperatur erwärmt werden können, um das Lotmaterial zum Schmelzen zu bringen. Wenn die Temperatur der magnetischen Nanopartikel allerdings die Curie-Temperatur überschreitet, wird eine weitere Erwärmung des Lotmittels unterbunden, da oberhalb dieser Temperatur im Wesentlichen kein Wärmeeintrag aus der Energie des Magnetfelds in die magnetischen Nanopartikel mehr stattfindet. Es kommt also zu einem automatischen Abschalten des Wärmeeintrags im Bereich der Curie-Temperatur der Nanopartikel, wodurch eine übermäßige thermische Belastung vorteilhaft vermieden werden kann. Insbesondere ist bei diesem Verfahren also der Wärmeeintrag nicht nur lokal auf den Bereich des Lotmittels konzentriert, sondern die Maximaltemperatur kann durch geeignete Wahl des Materials der Nanopartikel auf einen für die jeweilige Anwendung sinnvollen Bereich begrenzt werden. Die Curie-Temperatur der Nanopartikel hängt empfindlich von der genauen Zusammensetzung des enthaltenen ferromagnetischen bzw. ferrimagnetischen Materials ab, so dass durch die Materialwahl auch die Temperatur, bei der der automatische Abschalt-Mechanismus greift, gezielt gewählt werden kann. So kann die erreichbare Maximaltemperatur des Lotmittels nicht nur auf die Schmelztemperatur des metallischen Lotmaterials abgestimmt werden, sondern zweckmäßigerweise auch auf die thermische Belastbarkeit der Lotpartner sowie ggf. weiterer in der Baugruppe vorliegender Elemente. Dadurch kann die Baugruppe vorteilhaft auch temperaturempfindliche Elemente aufweisen wie zum Beispiel ein Gehäuse und/oder eine Isolationsschicht aus einem hitzeempfindlichen Polymer. Durch die lokal begrenzte Erwärmung und deren automatische Begrenzung kann deren Schädigung beim Lötprozess vermieden werden, wobei das metallische Lotmaterial trotzdem zuverlässig zum Schmelzen gebracht werden kann. Dabei kann das zur Erwärmung benötigte magnetische Wechselfeld auch durch andere Elemente hindurchdringen, welche ihrerseits beim Lötprozess kaum erwärmt werden, da sie eine geringe Wechselwirkung mit dem Magnetfeld aufweisen. So kann insbesondere das Löten an gesamten Anlagen, durch Bauelemente hindurch und sogar ein Lötprozess innerhalb einer Flüssigkeit oder durch eine Flüssigkeit hindurch ermöglicht werden.

Besonders vorteilhaft ist es im Zusammenhang mit dem beschriebenen Abschalt-Mechanismus, wenn die Verteilung der Curie-Temperaturen der einzelnen magnetischen Nanopartikel vergleichsweise eng ist. Es kann sich also vorteilhaft um sogenannte CNPs handeln (CNP für englisch "Curie temperature tuned magnetic nanoparticles"), also magnetische Nanopartikel mit aneinander angepasster Curie-Temperatur. Solche CNPs werden beispielsweise in der Veröffentlichung von R. Chaudhary, V. Chaudhary, R.V. Ramanujan, T.W.J. Steele "Magnetocuring of temperature failsafe epoxy adhesives" in Applied Materials Today 21 (2020) 100824, beschrieben.

So kann allgemein vorteilhaft die Verteilung der Curie-Temperaturen der einzelnen magnetischen Nanopartikel eine Halbwertsbreite (FWHM) von höchstens 50 °C, besonders vorteilhaft von höchstens 30 °C aufweisen. Wenn die Curie-Temperatur der einzelnen Nanopartikel derart eng aneinander angepasst ist, funktioniert die oben beschriebene automatische Begrenzung des Wärmeeintrags in einem besonders präzise definierten Temperaturfenster. Das Verfahren kann dann entsprechend den folgenden zusätzlichen Schritt umfassen: d) Erreichen der Curie-Temperatur der magnetischen Nanopartikel, so dass eine weitere Erhitzung des Lotmittels vermieden wird.

Mit anderen Worten führt das Erreichen der Curie-Temperatur der Nanopartikel zu einer schlagartigen Unterbrechung des Wärmeeintrags. So kann das Überschreiten einer vordefinierten Maximaltemperatur und damit auch das Vermeiden einer thermischen Schädigung benachbarter Elemente besonders zuverlässig vermieden werden. Insbesondere kann dabei auch auf eine komplexe Sensorik zur Temperaturerfassung und eine zusätzliche Regelungsvorrichtung zur Vermeidung von Überhitzungen verzichtet werden.

Gemäß einer allgemein vorteilhaften Ausführungsform umfassen die magnetischen Nanopartikel ein ferromagnetisches oder ferrimagnetisches Material, das insbesondere in Form einer metallischen Legierung oder eines Metalloxids vorliegt. Diese Legierung oder dieses Metalloxid weisen vorteilhaft zumindest eines der Elemente Eisen, Cobalt und Nickel auf. Dabei kann das Metalloxid insbesondere ein Mischoxid sein, beispielsweise eine Verbindung des Typs MnₓZn₁₋ₓFe₂O₄, wobei x insbesondere Werte zwischen 0,4 und 0,7 annehmen kann. Die Einstellung einer präzise definierten Curie-Temperatur wird für diesen Verbindungstyp im oben zitierten Paper von R. Chaudhary et al. beschrieben.

Weiterhin ist es allgemein vorteilhaft, wenn eine solche metallische Legierung bzw. ein solches Metalloxid einen Gewichtsanteil am gesamten Lotmittel aufweist, der zwischen 1% und 30% liegt. Ein Gewichtsanteil von wenigstens 1% ist dabei zweckmäßig, um über die Nanopartikel einen ausreichenden Wärmeeintrag in das Lotmittel bewirken zu können, der wiederum zu einem Aufschmelzen des metallischen Lotmaterials führt. Andererseits ist ein übermäßig hoher Gewichtsanteil oberhalb von 30 % generell unzweckmäßig, da dann die mechanischen und elektrischen Eigenschaften der Lötverbindung zu stark beeinträchtigt würden. Daher ist der Gewichtsanteil, wenn es auf eine besonders gute elektrische Leitfähigkeit der Lötverbindung ankommt, vorteilhaft sogar auf höchstens 10% zu begrenzen. Wenn es allerdings vor allem auf die Schaffung einer dauerhaften mechanischen Verbindung ankommt und die elektrische Leitfähigkeit von untergeordneter Bedeutung ist, dann kann der Gewichtsanteil der magnetischen Nanopartikel durchaus im oberen Teil dieses Bereichs, also zwischen 10 % und 30 % liegen.

Gemäß einer besonders vorteilhaften Ausführungsvariante können die magnetischen Nanopartikel einen Kern aus einem ferromagnetischen oder ferrimagnetischen Material und eine amagnetische Hülle aufweisen. Unter einem amagnetischen Material soll hier ein Material verstanden werden, welches jedenfalls nicht ferro- bzw. ferrimagnetisch ist. So kann die Hülle beispielsweise aus einem organischen Material gebildet sein und z.B. Ölsäure und/oder einen Bisphenol-A-Diglycidylether umfassen. Es kommen aber auch anorganische Materialien für die Hülle in Frage, beispielsweise Siliziumdioxid (SiO₂) oder Graphen. Eine solche Hülle kann insbesondere zur kolloidalen Stabilisierung der magnetischen Nanopartikel dienen. Mit anderen Worten wird durch sie eine Agglomeration der Partikel vermieden, welche beispielsweise durch den Einfluss von Feuchtigkeit ausgelöst werden kann. Hierzu kann die Dicke einer solchen kolloidal stabilisierenden Hülle beispielsweise in einem Bereich zwischen 2 nm und 10 nm liegen. Eine derart dünne Hülle kann ausreichend sein, um eine Agglomeration der Nanopartikel zu größeren Clustern zu verhindern und dementsprechend eine feine und annähernd homogene Verteilung der Nanopartikel über das gesamte Lotmittel zu ermöglichen. So kann eine besonders gleichmäßige Erwärmung des gesamten Lotmittels erreicht werden.

Alternativ zu dieser Ausführungsform ist es aber grundsätzlich auch möglich, unbeschichtete magnetische Nanopartikel zu verwenden. Dabei kann eine Bildung von Clustern solcher Nanopartikel gegebenenfalls in Kauf genommen werden. Insbesondere dann, wenn ein Partikelgemisch aus magnetischen Nanopartikeln und metallischen Lotpartikeln zum Einsatz kommt, kann es vorteilhaft sein, wenn die Größenskala der gebildeten Agglomerate im Bereich der Größenskala der eingesetzten Lotpartikel oder darunter liegt. Dann kann trotz der Agglomeration der Nanopartikel ein Lotmittel zur Verfügung gestellt werden, was homogen genug ist, um einen gleichmäßigen Wärmeübertrag von den magnetischen Nanopartikeln auf die metallischen Lotpartikel zu ermöglichen.

Gemäß einer ersten Ausführungsform des Lotmittels kann es sich dabei um eine Lotpaste handeln. Eine solche Lotpaste kann insbesondere ein Gemisch aus magnetischen Nanopartikeln und metallischen Lotpartikeln aufweisen. Solche Lotpartikel können vorteilhaft im Wesentlichen sphärisch sein und einen Durchmesser im Bereich zwischen 1 µm und 160 µm, insbesondere zwischen 2 µm und 50 µm, aufweisen. Dies entspricht dem üblichen Partikeldurchmesser in typischen herkömmlichen Lotpasten mit eher feinen Lotpartikeln.

Gemäß einer alternativen, zweiten Ausführungsform des Lotmittels kann es sich aber auch um ein festes Lotformteil handeln, das in der Fachwelt auch als Preform bezeichnet wird. Ein solches Lotformteil kann beispielsweise ein Lotring sein oder auch als Scheibe, als Band, als flaches Rechteck oder als Hufeisenform ausgebildet sein. Alternativ kann auch ein Lotdraht oder ein anderes festes Lotelement zum Einsatz kommen.

Allgemein und unabhängig davon, ob es sich um eine Lotpaste mit Lotpartikeln oder um ein Lotformteil handelt, kann es sich bei dem Lotmaterial um eine niedrigschmelzende Legierung handeln, beispielsweise um ein Weichlot, ein Hartlot oder ein Hochtemperaturlot. Für das Lotmaterial eignen sich grundsätzlich alle gängigen Lot-Legierungen, insbesondere Legierungen mit Zinn, Bismut, Silber, Kupfer, Zink, Blei und/oder Antimon.

Zusätzlich zu dem Lotmaterial und den magnetischen Nanopartikeln kann das Lotmittel allgemein vorteilhaft ein Flussmittel aufweisen. Auch dies gilt unabhängig davon, ob es sich beispielsweise um eine Lotpaste oder ein festes Lotformteil handelt. Auch für das Flussmittel kommen alle gängigen Materialen in Frage. So kann das Flussmittel beispielsweise ein Harz, ein Öl, ein Lösemittel, ein Salz oder Wasser sein oder eine solche Verbindung als Bestandteil umfassen. Insgesamt ist das Lotmittel ein Gemisch aus Materialen, das neben dem Lotmaterial, den magnetischen Nanopartikeln und dem optionalen Flussmittel gegebenenfalls auch noch weitere optionale Komponenten umfassen kann.

Gemäß einer allgemein vorteilhaften Ausführungsvariante des Verfahrens können in Schritt a) wenigstens zwei Magnetspulen mit einer unterschiedlichen Orientierung der magnetischen Pole eingesetzt werden. Bei dieser Ausführungsvariante werden somit zwei sich überlagernde magnetische Wechselfelder erzeugt, wobei vorteilhaft die Bereiche hoher magnetischer Flussdichte in einem Fokusbereich überlagert sind. Bei dieser Variante wird somit eine noch stärkere Fokussierung der lokalen Erwärmung auf einen eng eingegrenzten Bereich bewirkt als dies mit nur einer Magnetspule bzw. mit nur einer magnetischen Polrichtung möglich wäre. Die Größe des Fokusbereichs kann dabei je nach Anwendung recht unterschiedlich sein: So kann für Lötungen von Surface-Mount-Devices oder Ball Grid Arrays die Fokusgröße im Sub-Millimeter-Bereich liegen. Für großflächige Lötbereiche wie zum Beispiel im Bahntechnik-Bereich oder zum Löten von Rohren kann die Fokusgröße aber auch wesentlich größer sein und sogar im Meter-Bereich liegen.

Alternativ zu der Erzeugung eines engen Fokusbereichs mit zwei überlappenden Magnetfeldern kann eine Fokussierung des Magnetfeldes auch durch ein oder mehrere flussführende Elemente erreicht werden. So können zum Beispiel zwei konisch aufeinander zulaufende Eisenkerne zu beiden Seiten der Lötstelle angeordnet werden, um das Magnetfeld auf einen Fokusbereich mit geeigneter Größe zu bündeln.

Allgemein und unabhängig von der Anzahl und räumlichen Anordnung der verwendeten Magnetspulen kann die Frequenz des magnetischen Wechselfelds im Bereich einiger 100 kHz, insbesondere zwischen 100 kHz und 1000 kHz und beispielsweise im Bereich von etwa 400 kHz liegen. Bei einer Frequenz in einem solchen Bereich kann durch die entsprechenden Relaxationsprozesse in den magnetischen Nanopartikeln ein effizienter Wärmeeintrag in das Lotmittel erreicht werden.

Gemäß einer vorteilhaften Weiterbildung der Erfindung, die unabhängig von der Anzahl der Magnetspulen und der Zahl der magnetischen Pole ist, kann die wenigstens eine Magnetspule während des Lötverfahrens relativ zu den beiden Lötpartnern fortbewegt werden. Dabei ist es unerheblich, ob die Lötpartner ortsfest sind und die wenigstens eine Magnetspule bewegt wird oder umgekehrt. Insgesamt ergibt sich bei dieser Ausführungsform jedenfalls eine translatorische Relativbewegung, sodass der Fokusbereich bzw. der Bereich des maximalen Energieeintrags über die betreffende Baugruppe hinwegbewegt wird und so ein gezieltes lokales Aufschmelzen des Lotmittels an unterschiedlichen aufeinanderfolgenden Positionen ermöglicht wird. Vorteilhaft ermöglicht diese Ausführungsvariante des Verfahrens auch einen Verlauf, bei dem die jeweils aktive Lötzone von einem Bereich im Inneren der Baugruppe nach außen bewegt wird (und natürlich auch umgekehrt). So können mit dieser Variante, insbesondere wenn die Position des maximalen Energieeintrags räumlich eng begrenzt ist, auch einzelne lokale Lötstellen innerhalb einer komplexen Baugruppe geschaffen werden, und es ist gegebenenfalls auch eine nachträgliche Reparatur von solchen innenliegenden lokal begrenzten Lötstellen möglich. Eine Reparatur kann beispielsweise einen Austausch von Bauelementen sowie auch ein Aufschmelzen und Neupositionieren von fehlerhaft positionierten, bereits angelöteten Bauelementen umfassen. Alternativ oder zusätzlich ist mit der beschriebenen Art des Wärmeeintrags auch eine nachträgliche lokal begrenzte Wärmebehandlung zum Spannungsabbau in bereits geschaffenen Lötverbindungen möglich.

Gemäß einer allgemein vorteilhaften Weiterbildung des Verfahrens können innerhalb einer Baugruppe unterschiedliche Lotmittel mit unterschiedlichen Schmelztemperaturen zur Herstellung unterschiedlicher Arten von Lötverbindungen verwendet werden. Für zumindest eine Art dieser Lötverbindungen wird dann das erfindungsgemäße Lötverfahren eingesetzt. Bei den anderen Arten von Lötverbindungen kann dann entweder auch dieses erfindungsgemäße Verfahren mit einem anderen Lotmittel eingesetzt werden, oder aber es kann bei ein oder mehreren anderen Lötverbindungen ein herkömmliches Lötverfahren zum Einsatz kommen. So kann zum Beispiel für eine SMD-Lötverbindung ein anderes Verfahren eingesetzt werden als zum Anlöten eines Steckers oder eines Lastkontakts. Auch für das Löten von Verbindungen für Hochfrequenz-, Hochstrom- und/oder Hochspannungsanwendungen können andere Lötverfahren zum Einsatz kommen als für niedrigere Frequenz-, Strom- bzw. Spannungsbereiche. Schließlich kann auch für besondere Materialien wie z.B. ein bleihaltiges Lot ein anderes Verfahren verwendet werden als z.B. für ein bleifreies Lot an einer anderen Stelle der Baugruppe.

Gemäß einer vorteilhaften Ausführungsform der erfindungsgemäßen Baugruppe kann es sich um eine Elektronik-Baugruppe und insbesondere um eine leistungselektronische Baugruppe mit einem oder mehreren leistungselektronischen Bauelementen handeln. Hier kommen die Vorteile der Erfindung besonders zum Tragen, da es dabei meist sehr auf die Schaffung einer zuverlässigen und hoch elektrisch leitfähigen Lotverbindung ankommt, andererseits aber auch weitere Elemente innerhalb derselben Baugruppe vor einer übermäßigen thermischen Belastung geschützt werden müssen.

Allgemein vorteilhaft umfasst die Baugruppe jedenfalls zumindest eine Lötverbindung, welche mit dem erfindungsgemäßen Verfahren hergestellt ist. Durch diese Lötverbindung kann zweckmäßig eine elektrisch leitende Verbindung zwischen den zugehörigen Lötpartnern ausgebildet sein.

Gemäß einer vorteilhaften Ausführungsform der Baugruppe kann der erste Lötpartner ein elektrischer Schaltungsträger sein. Es kann sich also z.B. um eine Leiterplatte oder auch um einen keramischen Schaltungsträger handeln. In jedem Fall kann dieser Schaltungsträger die mechanische und/oder elektrische Basis der Baugruppe bilden, von der die weiteren Elemente getragen werden. Entsprechend können ein oder mehrere weitere Elemente, welche dann den zweiten und optional weitere Lötpartner ausbilden, auf diesen Schaltungsträger mit dem erfindungsgemäßen Verfahren aufgelötet sein.

Entsprechend kann der zweite Lötpartner ein elektrisches oder elektronisches Bauelement sein. Dies gilt auch für optional vorliegende weitere Lötpartner. Insbesondere kann ein Schaltungsträger mit ein oder mehreren solchen Bauelementen bestückt sein und mit diesen durch das erfindungsgemäße Lötverfahren verbunden worden sein. Dabei kann allgemein vorteilhaft eine elektrisch leitfähige Verbindung bereitgestellt werden, durch welche das betreffende Bauelement auch elektrisch kontaktiert ist. Bei einem solchen Bauelement kann es sich beispielsweise um einen IGBT, eine Diode, einen MOS-FET, einen Thyristor, einen Shunt oder einen Kondensator handeln.

Die Lötpartner müssen aber nicht zwangsläufig ein elektrischer Schaltungsträger und ein elektrisches Bauelement sein. Es können auch beliebige andere Bauteile wie zum Beispiel ein Rohr oder ein Maschinengehäuse den ersten Lötpartner bilden, und es können beliebige andere Bauteile den zweiten Lötpartner bilden. So kann zum Beispiel ein Sensor (insbesondere für Temperatur oder mechanische Spannungen) auf ein Rohr oder Maschinengehäuse gelötet werden. Alternativ kann die Löttechnik auch im Feldeinsatz für Reparaturen verwendet werden, z.B. um mehrere Rohrteile aneinander zu löten.

Nachfolgend wird die Erfindung anhand einiger bevorzugter Ausführungsbeispiele unter Bezugnahme auf die angehängten Zeichnungen beschrieben, in denen:
- Figur 1: eine schematische Querschnittsdarstellung eines Teils einer Baugruppe während des Lötverfahrens nach einem ersten Beispiel der Erfindung zeigt,
- Figur 2: einen Detailausschnitt eines Lotmittels für eine solche Lötverbindung zeigt,
- Figur 3: eine schematische perspektivische Ansicht eines Teils einer Baugruppe zusammen mit den beim Lötverfahren eingesetzten Magnetspulenanordnungen zeigt und
- Figur 4: eine Querschnittsdarstellung einer Baugruppe während der Herstellung der Lötverbindung nach einem weiteren Beispiel der Erfindung zeigt.

In den Figuren sind gleiche oder funktionsgleiche Elemente mit gleichen Bezugszeichen versehen.

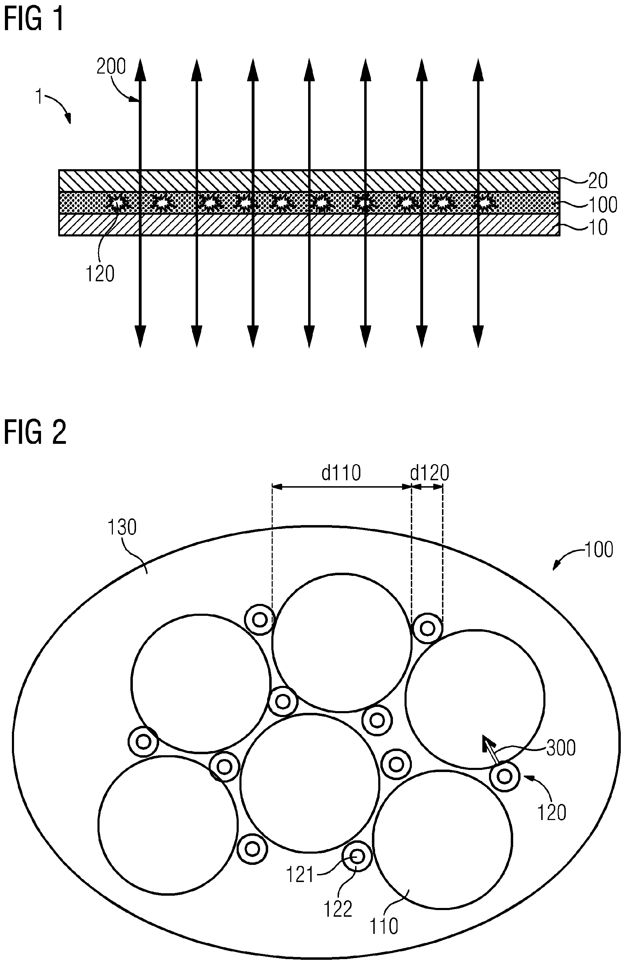

So zeigt Figur 1 einen Teil einer Baugruppe 1 nach einem ersten Beispiel der Erfindung im schematischen Querschnitt. In dem gezeigten Detailausschnitt dieser Baugruppe 1 wird mit dem erfindungsgemäßen Verfahren eine Lötverbindung zwischen einem ersten Lötpartner 10 und einem zweiten Lötpartner 20 erzeugt. Hierbei kann es sich prinzipiell um beliebige Elemente der Baugruppe handeln, die durch Löten dauerhaft mechanisch verbunden werden sollen. Gegebenenfalls kann dabei auch eine elektrisch gut leitfähige Verbindung und somit eine elektrische Kontaktierung der beiden Lötpartner 10 und 20 geschaffen werden. Die herzustellende Lötverbindung wird hier durch ein Lotmittel 100 vermittelt, welches einerseits ein metallisches Lotmaterial als Komponente umfasst und zusätzlich eine Vielzahl von magnetischen Nanopartikeln 120 umfasst, die in das Lotmittel 100 eingebettet sind. Dabei kann das Lotmittel 100 prinzipiell auf unterschiedliche Weise ausgestaltet sein. Es kann sich beispielsweise um eine Lotpaste handeln oder auch um ein festes Lotformteil. In jedem Fall sind die magnetischen Nanopartikel 120 über das Volumen des Lotmittels verteilt. Beim Beispiel der Figur 1 kann es sich insbesondere bei dem Lotmittel 100 um eine Lotpaste handeln, welche ein Partikelgemisch aus metallischen Lotpartikeln und magnetischen Nanopartikeln beinhaltet.

Um die Lötverbindung zwischen den beiden Lötpartnern 10 und 20 auszubilden, wird ein magnetisches Wechselfeld 200 erzeugt, wie in Figur 1 durch entsprechende Doppelpfeile angedeutet. Dieses magnetische Wechselfeld wirkt auf den Bereich des Lotmittels 100 ein. Insbesondere findet eine magnetische Wechselwirkung mit den darin enthaltenen magnetischen Nanopartikeln 120 statt, die zu einer Erwärmung dieser Nanopartikel führt. Die in das Lotmittel 100 eingebetteten magnetischen Nanopartikel werden also unter Einwirkung des magnetischen Wechselfeldes 200 zu lokalen Wärmequellen innerhalb des Lotmittels 100, von denen eine Wärmeübertragung auf die übrigen Komponenten des Lotmittels erfolgt. Durch diesen Wärmeeintrag, der sehr lokal ist und im Wesentlichen auf den Bereich des Lotmittels 100 begrenzt ist, wird das metallische Lotmaterial in dem Lotmittel zum Schmelzen gebracht. Nach dem Abschalten des magnetischen Wechselfeldes kommt es zu einer Abkühlung des Lotmittels und entsprechend zum Erstarren dieser Schmelze, wodurch eine dauerhafte Lötverbindung zwischen den beiden Lötpartnern 10, 20 ausgebildet wird.

Wenn durch die lokale Erhitzung der magnetischen Nanopartikel deren Curie-Temperatur überschritten wird, kommt es zu einer automatischen Unterbrechung des Wärmeeintrags in das Lotmittel. So wird die erreichte Temperatur automatisch begrenzt. Durch diesen Effekt, in Verbindung mit der lokal begrenzten Erwärmungszone, handelt es sich daher um ein besonders schonendes Lötverfahren, bei dem eine thermische Schädigung von optional vorliegenden weiteren Elementen der Baugruppe vorteilhaft vermieden wird. Auch der Wärmeeintrag in die beiden zu verbindenden Lötpartner 10 und 20 ist dabei relativ niedrig.

In Figur 2 ist ein Detailausschnitt im Bereich eines Lotmittels 100 gezeigt, wie es beispielsweise bei dem Lötverfahren der Figur 1 zum Einsatz kommen kann. Auch hier handelt es sich bei dem Lotmittel 100 um eine Lotpaste mit einer Vielzahl von metallischen Lotpartikeln 110. Diese sind hier als annähernd sphärische Lotkugeln aus einer vergleichsweise niedrig schmelzenden metallischen Legierung ausgebildet. Ihr Durchmesser d110 kann beispielsweise im Bereich einiger Mikrometer bis einiger 10 Mikrometer liegen. Neben diesen metallischen Partikeln umfasst die Paste außerdem eine Vielzahl von magnetischen Nanopartikeln 120, wie bereits vorab beschrieben. Zusätzlich enthält die Lotpaste in diesem Beispiel auch noch ein (optionales) organisches Flussmittel 130. Der Durchmesser d120 der magnetischen Nanopartikel 120 ist wesentlich kleiner als der Durchmesser d110 der metallischen Lotkugeln 110. Vorteilhaft ist die Größenskala der magnetischen Nanopartikel 120 im Bereich von 100 nm oder darunter. Diese Nanopartikel enthalten eine ferromagnetische oder ferrimagnetische Materialkomponente. Aufgrund der geringen Partikelgröße sind die Nanopartikel insgesamt superparamagnetisch. Diese Eigenschaft ermöglicht eine starke lokale Erwärmung der magnetischen Nanopartikel im magnetischen Wechselfeld und somit den für das Lötverfahren benötigten Energieeintrag in das Lotmittel 100. Wie durch den beispielhaften Pfeil 300 angedeutet, findet dabei auch eine Wärmeübertragung von den Nanopartikeln 120 auf die metallischen Lotpartikel 110 statt, wodurch diese aufgeschmolzen werden.

Beim Beispiel der Figur 2 weisen die magnetischen Nanopartikel zwei Materialkomponenten auf, nämlich einen Kern 121 aus einem ferromagnetischen oder ferrimagnetischen Material und eine amagnetische Hülle 122. Dies ist nicht zwingend erforderlich, und die Nanopartikel können alternativ auch nur aus einem einheitlichen ferro- oder ferrimagnetischen Material bestehen. Die gezeigte Kern-Hülle-Struktur kann aber vorteilhaft sein, da durch die Beschichtung mit dem Hüllenmaterial insbesondere eine zu starke Agglomeration der einzelnen Nanopartikel vermieden werden kann.

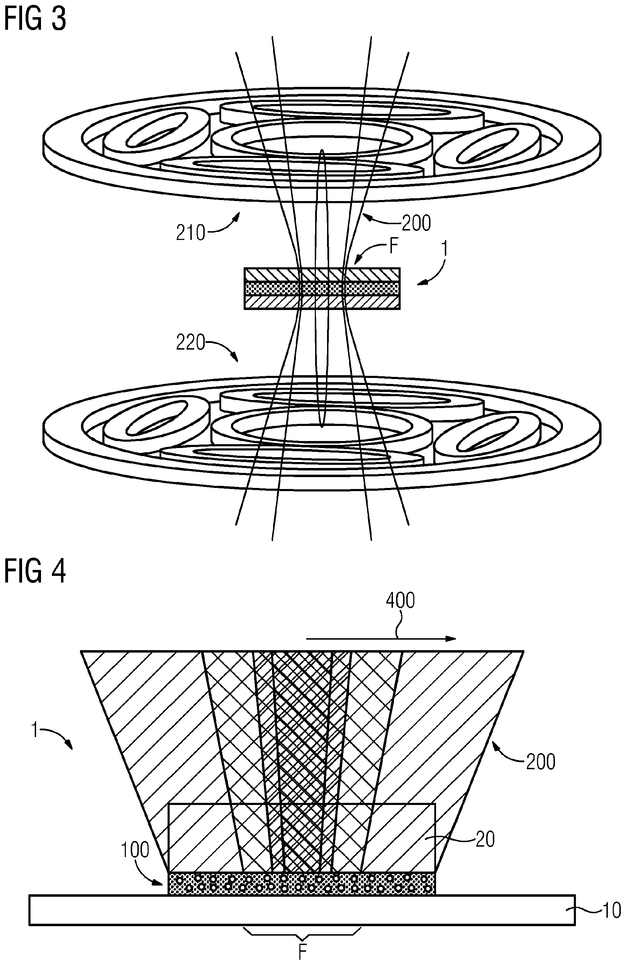

In Figur 3 ist eine schematische teil-perspektivische Ansicht eines Teils einer Baugruppe 1 gezeigt, welcher zur Durchführung des erfindungsgemäßen Verfahrens im Fokusbereich F eines magnetischen Wechselfeldes 200 platziert ist. Ansonsten kann die Baugruppe 1 ähnlich ausgebildet sein wie beim Beispiel der Figur 1 und insbesondere ein ähnliches Lotmittel 100 zur Ausbildung der Lötverbindung umfassen. Der Fokusbereich F kann vergleichsweise schmal ausgebildet sein, so dass der Energieeintrag in das Lotmittel räumlich eng begrenzt ist. Um dies zu erreichen, sind hier zur Erzeugung des magnetischen Wechselfeldes 200 zwei Magnetspulenanordnungen 210 und 220 vorgesehen. Sie befinden sich bei diesem Beispiel auf gegenüberliegenden Seiten der Baugruppe, so dass sich die Baugruppe 1 in der Mitte zwischen den beiden Spulenanordnungen befindet. Bei diesem Beispiel liegen die magnetischen Pole der beiden Spulenanordnungen 210 und 220 koaxial aufeinander. Alternativ ist aber auch möglich, dass zwei oder mehr Magnetspulen mit unterschiedlichen Orientierungen der zugehörigen magnetischen Pole eingesetzt werden. Insbesondere können sich die magnetischen Pole dann im Fokusbereich F kreuzen, was unter Umständen eine noch stärkere Fokussierung des Energieeintrags erlaubt.

In Figur 4 ist eine Querschnittsdarstellung einer weiteren Baugruppe 1 gezeigt, bei der wiederum eine Lötverbindung mit dem erfindungsgemäßen Verfahren erzeugt wird. Bei diesem Beispiel ist der erste Lötpartner ein elektrischer Schaltungsträger 10, und der zweite Lötpartner ist ein elektronisches Bauelement 20. Insbesondere handelt es sich beim zweiten Lötpartner um einen Halbleiterchip, welcher auf den Schaltungsträger bestückt wurde und durch das Lötverfahren elektrisch leitend mit Leiterbahnen auf dem Schaltungsträger 10 verbunden werden soll. Auch hier liegt zwischen den beiden Lötpartnern 10 und 20 ein Lotmittel 100 vor, welches ähnlich wie bei den vorhergehenden Beispielen eine metallische Lotkomponente und über das Lotmittel 100 verteilte magnetische Nanopartikel umfasst. Auch hier wirkt ein magnetisches Wechselfeld 200 auf den Lötbereich ein, wobei wiederum ein relativ enger Fokusbereich F gebildet ist, in dem der Energieeintrag aus dem Magnetfeld 200 ausreichend hoch ist, um die metallische Lotkomponente zum Schmelzen zu bringen. Insbesondere ist die laterale Abmessung des Fokusbereichs kleiner als die laterale Abmessung des Chips, so dass auch ein punktuelles lokales Aufschmelzen des Lotmittels 100 in einem Teilbereich unter dem Chip möglich ist. Durch den Pfeil 400 ist angedeutet, dass während des Lötverfahrens eine Relativbewegung zwischen dem magnetischen Wechselfeld (bzw. der magnetfelderzeugenden Spulenanordnung) einerseits und der Baugruppe 1 andererseits durchgeführt wird. Hierdurch kann der erhitzte Lötbereich ganz gezielt auf einen engen Teilbereich der Baugruppe begrenzt werden. Außerdem verdeutlicht Figur 4, dass das magnetische Wechselfeld auch durch den Chip 20 und/oder andere Elemente der Baugruppe hindurchdringen kann, ohne in diesen Elementen eine signifikante Erwärmung zu bewirken, da der wesentliche Energieeintrag auf den Bereich des Lotmittels 100 mit den magnetischen Nanopartikeln begrenzt ist.

### Bezugszeichenliste

- 1: Baugruppe
- 10: erster Lötpartner (Schaltungsträger)
- 20: zweiter Lötpartner (Bauelement)
- 100: Lotmittel
- 110: metallisches Lotmaterial (Lotpartikel)
- 120: magnetische Nanopartikel
- 121: Kern
- 122: Hülle
- 130: Flussmittel
- 200: magnetisches Wechselfeld
- 210: erste Magnetspulenanordnung
- 220: zweite Magnetspulenanordnung
- 300: Wärmeübertragung
- 400: Relativbewegung
- d110: Durchmesser der metallischen Lotpartikel
- d120: Durchmesser der magnetischen Nanopartikel
- F: Fokusbereich

## Patentansprüche

1. Verfahren zum Herstellen einer Lötverbindung zwischen einem ersten Lötpartner (10) und einem zweiten Lötpartner (20) durch ein Lotmittel (100),
wobei das Lotmittel ein metallisches Lotmaterial (110) und eine Vielzahl von magnetischen Nanopartikeln (120) umfasst,
wobei das Verfahren zumindest die folgenden Schritte aufweist:
a) Erzeugung eines magnetischen Wechselfelds (200) mit wenigstens einer Magnetspule (210,220) und Einwirkung des magnetischen Wechselfeldes (200) auf das Lotmittel (100),
b) Erhitzung der magnetischen Nanopartikel (120) durch die Wechselwirkung mit dem magnetischen Wechselfeld (200),
c) Aufschmelzen des metallischen Lotmaterials (110) aufgrund von Wärmeübertragung (300) von den magnetischen Nanopartikeln (120) auf das metallische Lotmaterial (110) und Ausbildung der Lötverbindung zwischen dem ersten Lötpartner (10) und dem zweiten Lötpartner (20) durch das geschmolzene metallische Lotmaterial (110).

2. Verfahren nach Anspruch 1, bei welchem die magnetischen Nanopartikel (120) superparamagnetisch sind.

3. Verfahren nach einem der Ansprüche 1 oder 2, bei welchem die magnetischen Nanopartikel (120) einen Durchmesser (d120) unterhalb von 100 nm aufweisen.

4. Verfahren nach einem der vorhergehenden Ansprüche, bei welchem die magnetischen Nanopartikel (120) eine Curie-Temperatur aufweisen, welche in einem Bereich zwischen 100°C und 1200 °C, insbesondere zwischen 150 °C und 400 °C, liegt.

5. Verfahren nach einem der vorhergehenden Ansprüche, bei welchem die Verteilung der Curie-Temperaturen der einzelnen magnetischen Nanopartikel (120) eine Halbwertsbreite (FWHM) von höchstens 50 °C, insbesondere von höchstens 30 °C aufweist.

6. Verfahren nach einem der vorhergehenden Ansprüche, welches den folgenden zusätzlichen Schritt umfasst:
d) Erreichen der Curie-Temperatur der magnetischen Nanopartikel (120), so dass eine weitere Erhitzung des Lotmittels (100) vermieden wird.

7. Verfahren nach einem der vorhergehenden Ansprüche, bei welchem die magnetischen Nanopartikel (120) ein ferromagnetisches oder ferrimagnetisches Material, insbesondere in Form einer metallischen Legierung oder eines Metalloxids umfassen, wobei die Legierung oder das Metalloxid zumindest eines der Elemente Eisen, Cobalt und Nickel aufweist.

8. Verfahren nach Anspruch 7, bei welchem die metallische Legierung oder das Metalloxid einen Gewichtsanteil am gesamten Lotmittel zwischen 1% und 30% aufweisen.

9. Verfahren nach einem der vorhergehenden Ansprüche, bei welchem die magnetischen Nanopartikel (120) einen Kern (121) aus einem ferromagnetischen oder ferrimagnetischen Material und eine amagnetische Hülle (122) aufweisen.

10. Verfahren nach einem der vorhergehenden Ansprüche, bei welchem in Schritt a) wenigstens zwei Magnetspulen (210,220) mit einer unterschiedlichen Orientierung der magnetischen Pole eingesetzt werden.

11. Verfahren nach einem der vorhergehenden Ansprüche, bei welchem die wenigstens eine Magnetspule (210,220) relativ zu den beiden Lötpartnern (10,20) fortbewegt wird.

12. Verfahren nach einem der vorhergehenden Ansprüche, bei welchem innerhalb einer Baugruppe (1) unterschiedliche Lotmittel (100) mit unterschiedlichen Schmelztemperaturen zur Herstellung unterschiedlicher Arten von Lötverbindungen verwendet werden.

13. Baugruppe (1) mit einem ersten Lötpartner (10) und einem zweiten Lötpartner (20),
wobei die beiden Lötpartner (10,20) durch ein Lotmittel (100) verbunden sind, welches eine metallisches Lotmaterial (110) und eine Vielzahl von darin eingebetteten magnetischen Nanopartikeln umfasst.

14. Baugruppe (1) nach Anspruch 13, bei welcher der erste Lötpartner (10) ein elektrischer Schaltungsträger ist.

15. Baugruppe (1) nach einem der Ansprüche 13 oder 14, bei welcher der zweite Lötpartner (20) ein elektrisches oder elektronisches Bauelement ist.
